# EUROPEAN PATENT SPECIFICATION

(11) **EP 2 553 137 B1**
(45) Date of publication and mention of the grant of the patent: **05.10.2016**
(21) Application number: 11763437.8
(22) Date of filing: 31.03.2011
(51) Int. Cl.: C23C 14/35, H01J 37/34

(54) **ROTATING MAGNETRON SPUTTERING CATHODE APPARATUS AND METHOD OF DEPOSITING MATERIAL WITH THE SAME**
ROTIERENDE KATHODENVORRICHTUNG ZUR MAGNETRON ZERSTÄUBUNG UND VERFAHREN ZUM ABSCHEIDEN VON MATERIAL DAMIT
DISPOSITIF DE CATHODE ROTATIF POUR PULVÉRISATION MAGNÉTRON ET MÉTHODE DE DÉPÔT DE MATÉRIEL UTILISANT CELUI-CI

(30) Priority: 12.04.2010 US 323037 P; 31.03.2010 US 319592 P
(43) Date of publication of application: 06.02.2013
(73) Proprietor: Mustang Vacuum Systems, Inc., Sarasota, FL 34243 (US)
(72) Inventor: CHOQUETTE, Robert, Sarasota, FL 34243 (US); GREENWELL, Richard, Sarasota, FL 34243 (US); DICKEY, Aaron, Sarasota, FL 34243 (US); EGLE, Lawrence, Sarasota, FL 34243 (US)
(74) Representative: D Young & Co LLP
(86) International application number: PCT/US2011/030726
(87) International publication number: WO 2011/123646

(56) References cited:
- WO-A1-92/01081
- US-A- 5 225 393
- US-A1- 2006 090 999
- US-A1- 2009 145 746
- US-A1- 2010 051 445
- US-B1- 6 488 824
- US-B1- 6 488 824
- US-B2- 6 841 051

## Description

This application claims priority to U.S. Provisional Applications 61/359,592 and 61/323,037.

### BACKGROUND

The present invention relates to a rotating magnetron sputtering cathode apparatus utilizing a cylindrical cathode and radio frequency emissions, and a method of depositing material with a rotating cylindrical magnetron sputtering cathode apparatus using radio frequency emissions. Sputtering rotating magnetron cathode apparatuses utilizing cylindrical cathodes are known in the art. However, such apparatuses are adapted for operation with direct current or low- to medium-frequency alternating current, and do not operate using radio frequency ("RF") emissions. As a result, such apparatuses generally require metal doping to deposit non-metallic materials.

The present invention overcomes such limitations by providing a cylindrical rotating magnetron sputtering cathode apparatus that incorporates electrical isolation of the cathode and electrode, components formed of non-ferrous materials, liquid cooling, and improved power delivery. Significantly, the apparatus of the present invention is fully capable of RF operation and provides a method of depositing materials, including oxides, with RF emissions that reduces or eliminates the need for metal doping.

The distinction between alternating current and RF is understood in the art. While RF current is an alternating current as opposed to a direct current, the energy transmitted by an RF power supply need not be transmitted by direct electrical contact. Instead, RF energy may be transmitted through a medium (such as air or water) to the target material. In this way, an electrode attached to an RF power supply can be seen as acting as an antenna transmitting RF emissions as opposed to acting purely as a conductor of an alternating current. Traditionally, rotating magnetron sputtering cathode apparatuses utilizing a cylindrical cathode, which are adapted for operation with alternating current, have utilized two rotating cathodes and are adapted such that the power signal alternates between them. Such arrangements are not required where RF power is utilized. However, RF power can generate inductive and magnetic effects that previously made it impractical to sputter materials using RF emissions with rotating cylindrical cathodes. The present invention addresses these limitations and allows for RF operation of a rotating magnetron sputtering cathode apparatus utilizing a single cylindrical cathode. Document US-B2-6841051 discloses a rotating cylindrical magnetron sputtering cathode apparatus comprising a stationary, AC-powered, electrically conductive, cooling member, which is disposed longitudinally within the cathode, and which supports a magnet array.

Document US-B1-6488824 discloses a magnetron sputtering apparatus, which is driven with radio frequency power to sputter non-conductive materials.

Document US5225393 discloses the forming of a thin oxide film using a radio frequency planar magnetron sputtering apparatus and an oxide target.

### SUMMARY

Disclosed herein is a rotating magnetron sputtering cathode apparatus according to claim 1.

While the cathode could be entirely made up of the material to be deposited (the target material), in other embodiments only a portion of the outer surface of the cathode will comprise the target material, with the remainder of the cathode comprising other materials. The electrode is electrically isolated from the shaft, and is preferably not in direct electrical contact with the cathode, but may be in direct contact in some embodiments.

To address issues created by magnetic fields induced by high frequency operation, the electrode and shaft are preferably formed from non-ferrous materials. The shaft is generally coaxial with the cathode and is mechanically connected to the cathode such that rotating the shaft causes the cathode to rotate about the magnetic field source and a portion of the electrode. The connection is such that the shaft and said cathode are also electrically isolated so that electrical energy is not transmitted directly from the cathode to the shaft in substantial quantities. The drive motor is adapted to rotate the shaft and, thereby the cathode, and the power supply is adapted to supply RF energy at frequencies of 1 MHz or higher, with no set upper limit. The electrode is electrically connected to the power supply and transmits the RF emissions generated by the power supply to the cathode during operation. The RF energy causes the cathode to eject particles of the target material as the cathode rotates, preferably onto a substrate positioned near the cathode.

Also disclosed is a method of depositing material with a rotating cylindrical magnetron sputtering cathode apparatus, according to claim 12. The apparatus likewise comprises an RF power supply, a power delivery assembly, a rotating cathode, a shaft and a drive motor. The power delivery assembly preferably comprises a magnetic field source positioned within the rotating cylindrical cathode and an electrode extending within the cathode. At least a portion of the outer surface of the cathode comprises a target material, but the entire cathode may be formed of target material as well in certain embodiments. The electrode is electrically isolated from the shaft, which is generally coaxial with the cathode. The electrode and shaft are formed from non-ferrous materials. Utilizing such an apparatus, the method disclosed herein comprises the steps of causing the power supply to supply radio frequency energy at frequencies of 1 MHz or higher to the electrode, causing the cathode to rotate about the magnetic field source, and positioning a substrate proximate to the outside surface of the cathode, which comprises the target material. During operation, RF energy from the RF power supply causes particles of the target material to eject onto the substrate.

### BRIEF DESCRIPTION OF THE DRAWINGS

Other features of the invention will become apparent from the attached drawings, which illustrate certain preferred embodiments of the apparatus of this invention, wherein
Fig. 1 is an exploded perspective view of an embodiment of the apparatus of the present invention, and which is suitable for use with the methods of the present invention;
Fig. 2 is a perspective view of the embodiment shown in Fig. 1, in assembled form;
Fig. 3 is a partial cross section view of the embodiment illustrated in Fig. 2, showing the connection between the shaft and the rotating cathode, as referenced by line 3 in Fig. 2;
Fig. 4 is an exploded-perspective view of the portion of the power delivery assembly of the embodiment illustrated in Fig. 1 within and proximate to the cathode;
Fig. 5 is a perspective view of the power delivery assembly shown in Fig. 4, in assembled form;
Fig. 6 is an exploded, perspective view of the magnetic field source of the embodiment illustrated in Fig. 1, without magnets installed;
Fig. 7 is an exploded, perspective view of the cathode assembly of the embodiment illustrated in Fig. 1;
Fig. 8 is an exploded, perspective view of the shaft assembly of the embodiment shown in Fig. 1;
Fig. 9 is a perspective view of the shaft assembly shown in Fig. 7, in assembled form;
Fig. 10 is an exploded, perspective view of the drive motor assembly of the embodiment shown in Fig. 1;
Fig. 11 is an exploded, perspective view of the mounting plate assembly of the embodiment shown in Fig. 1;
Fig. 12 is an exploded, perspective view of the inner housing assembly of the embodiment shown in Fig. 1;
Fig. 13 is a cross section view of the inner housing assembly shown in Fig. 12, referenced by line 13 in Fig. 12;
Fig. 14 is an exploded, perspective view of the outer housing assembly of the embodiment shown in Fig. 1; and
Fig. 15 is a cross section view of the outer housing assembly shown in Fig. 14, referenced by line 15 in Fig. 14.

### DETAILED DESCRIPTION

While the following describes preferred embodiments of the apparatus and methods of the present invention, it is to be understood that this description is to be considered only as illustrative of the principles of the invention and is not to be limitative thereof. Numerous other variations, all within the scope of the present invention, will readily occur to others, which invention shall be limited only by the claims herein.

The term "adapted" shall mean sized, shaped, configured, dimensioned, oriented and arranged as appropriate.

The term "radio frequency" or "RF" will denote frequencies of 1 MHz or higher, without upper limit.

The term "electrically isolated" shall mean, with respect to two components, that there is no conductive connection between the components that would enable a direct current to flow from one to the other in substantial quantities.

The term "doping" shall mean the practice of including a predetermined amount of a material into a target material to change the sputtering characteristics of the target material. Thus, a "doped material" shall refer to a target material in which doping was used. Doping is commonly used to enable sputtering of insulating materials by doping the insulating target material with conductive materials such as metals. Other types of doping, in which materials other than metals, are added to target materials are also possible.

The term "non-ferrous" when used to describe a material shall indicate the material is substantially free of iron or is a non-magnetic metal such as aluminum, brass, or 304 stainless steel.

Where a number is used immediately preceding "stainless steel" (e.g. "304 stainless steel"), the number refers to a grade of stainless steel and not an element number shown in the figures. Where specific materials such as particular grade of stainless steel are referenced in this detailed description, the reference is intended to disclose one example of an appropriate material which may be used, and is not intended to limit the present invention to components formed of those materials.

Where reference is made herein to insulating ceramic bearings, such bearings are available in a variety of materials including, without limitation, Zirconia oxide, and are available from a variety of sources including, without limitation, Impact Bearings of San Clemente, California.

Rotating cylindrical cathode sputtering systems typically include a power source, a cathode, and a magnet assembly. The power source is connected to the cathode through an electrode and the magnet is positioned within the rotating cathode. The cathode (or "target") is then placed in a substantially evacuated chamber together with an object to be coated and an inert gas, such as Argon. Power is applied to the rotating cathode through the electrode as a substrate is passed over the rotating cathode. The combination of the energy from the power source, the magnetic field of the magnet assembly and the Argon gas, causes particles to be ejected from the target material of the cathode, and onto the substrate, thereby coating the substrate with target material.

Known sputtering cylindrical cathode deposition systems operate using direct current (DC) or low- to medium-frequency (typically in the kilohertz range) alternating current (AC). Where insulating target materials (such as ceramics or oxides) are to be deposited, such devices typically require the use of metal doping for effective sputtering. Such systems often rely on the reactive nature of oxygen to eliminate the metal doping material during deposition. Such elimination, however, may not be complete or even. The result can be pinholes or impurities in the deposited film, and may require coatings of a higher thickness than would otherwise be desirable, or the use of secondary processes.

The apparatus and methods of the present invention allows for use of radio-frequency (RF) power in the sputtering operation. The use of RF power allows for sputtering of non-conductive materials such as ceramics and oxides with minimal or no metal doping, allows for higher quality coatings with fewer imperfections, and reduces the need for secondary processing, thereby allowing for more efficient operation. Problems that occur when attempting to sputter with RF energy include inductive heating and magnetic effects caused by the RF energy in ferrous components. The present invention addresses these problems and enables RF sputtering of un-doped insulating materials with a rotating magnetron cylindrical cathode sputtering apparatus. The present invention also allows, in certain preferred embodiments, the use of only one cathode, whereas prior-known AC sputtering devices typically use two electrically-linked cathodes. Other embodiments of the present invention allow for the use of multiple cathodes, but it is understood that the use of multiple cathodes is rendered optional by the present invention.

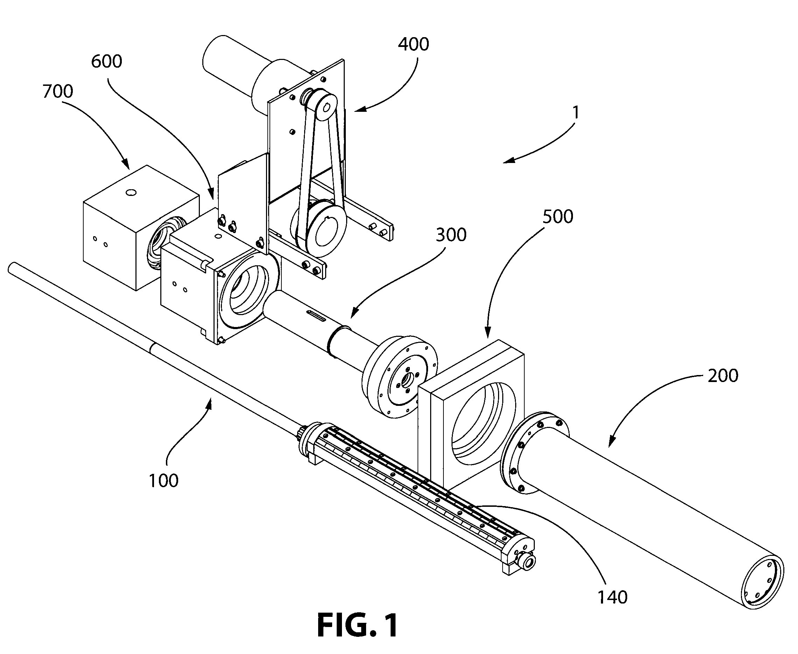

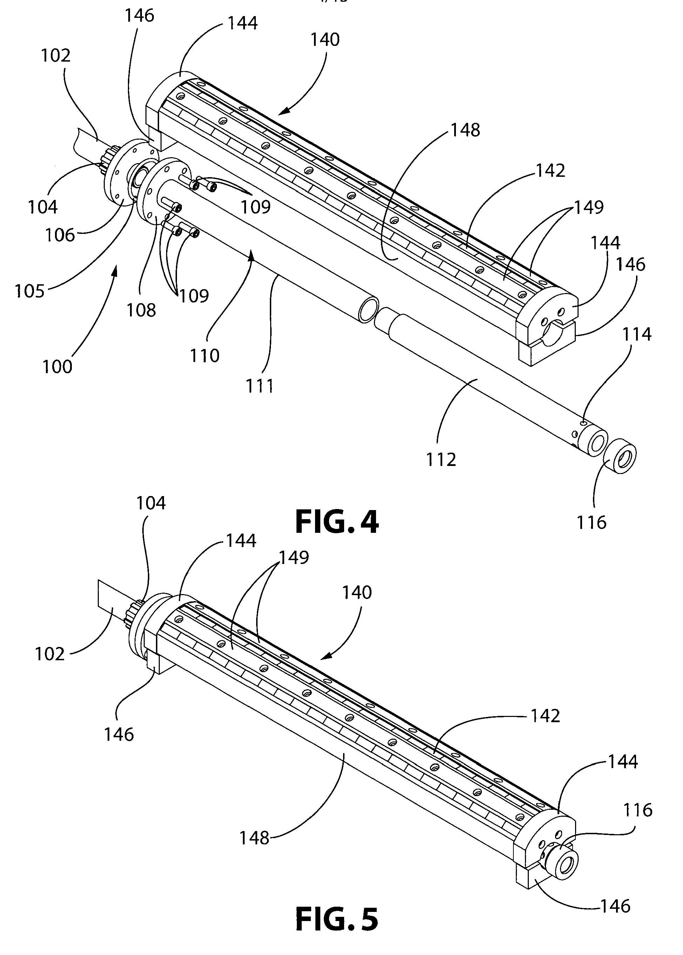

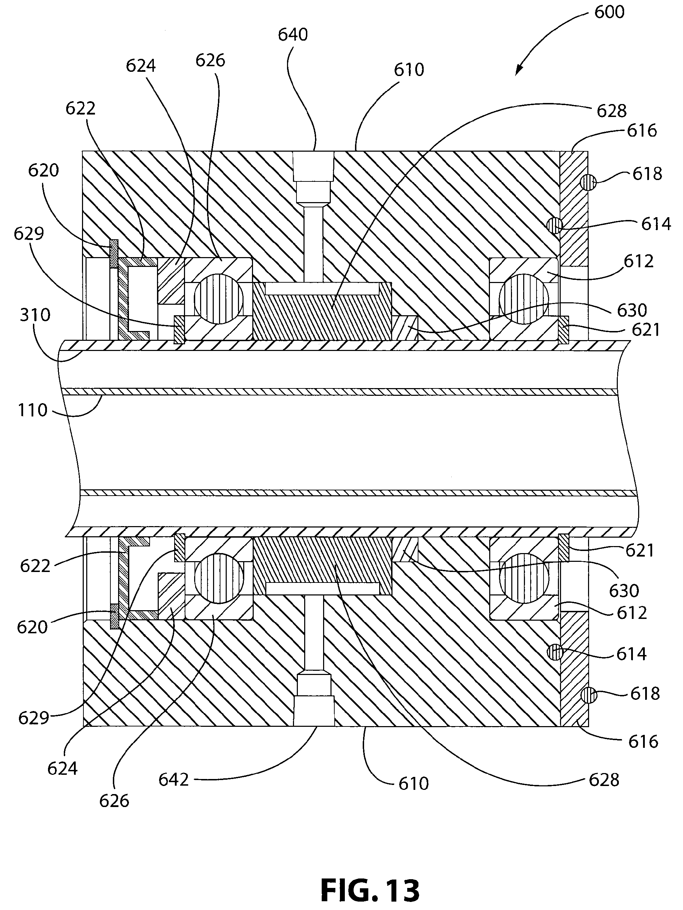

Figs. 1-15 illustrate a preferred embodiment of the rotating magnetron sputtering cathode apparatus 1 of the present invention, with figs. 1-3 illustrating the major components, and figs. 4-15 showing those components in greater detail.

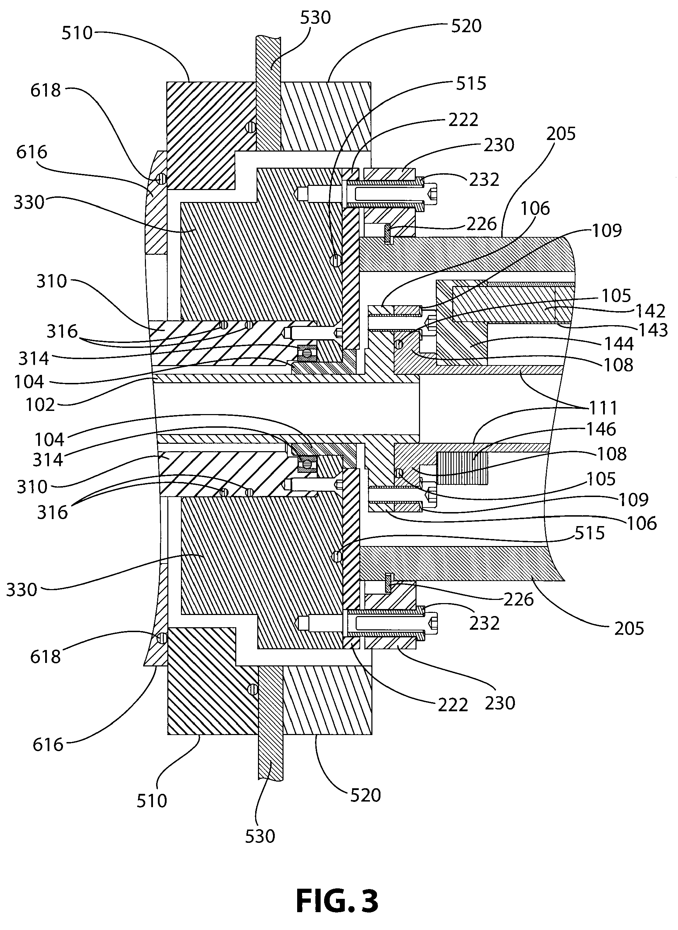

Referring to Figs. 1-3, sputtering cathode apparatus 1 comprises a radio frequency power supply 800, a power delivery assembly 100, a cylindrical rotating cathode 200, a shaft assembly 300 and a drive motor assembly 400. Cathode 200 extends into a substantially evacuated chamber (not illustrated), while shaft assembly 300 and drive motor assembly 400 remain outside. Mounting plate assembly 500 connects to the wall (512 on Fig. 3) of the evacuated chamber (not illustrated) and creates a substantially air-tight seal. The connection of mounting plate assembly 500 to the wall 512 may suitably be a mechanical connection or a welded connection.

Shaft assembly 300 passes into mounting plate assembly 500 and mechanically connects to cathode 200. The interfaces between cathode 200 and mounting plate assembly 500, and/or between shaft assembly 300 and mounting plate assembly 500 are adapted to minimize or eliminate leaks in the substantially evacuated chamber (not illustrated), as is understood by those of ordinary skill in the art.

As is illustrated, shaft assembly 300 is generally coaxial with cathode 200. The connection between shaft assembly 300 and cathode 200 is adapted such that rotation of shaft assembly 300 causes rotation of cathode 200, but isolates cathode 200 from shaft assembly 300 electrically. Preferably, little or no electrical energy should transfer between shaft assembly 300 and cathode 200 through direct electrical contact/ conduction. In this way, the energy transfer to cathode 200 during operation is entirely, or almost entirely, through power deliver assembly 100. The result is more efficient delivery of power to cathode 200 than would otherwise occur. A suitable means of connection is described further below.

Drive motor assembly 400 is adapted to rotate shaft assembly 300. While a variety of rotation speeds may be used, and the present invention is not limited to any particular range of rotation speeds, speeds between one rotation per minute and twelve rotations per minute are suitable for most applications with the apparatus of the present invention. Drive motor assembly 400 may conveniently attach to outer housing assembly 700 and inner housing assembly 600 with mechanical fasteners.

As illustrated in Figs. 4 and 5, power delivery assembly 100 comprises magnetic field source 140 and electrode 110. As shown in Fig. 3, power delivery assembly 100 extends through shaft assembly 300 and mounting plate assembly 500, to within cathode 200 such that magnetic field source 140 is positioned within cathode 200 and electrode 110 extends into cathode 200. Power delivery assembly 100, and in particular, electrode 110 are electrically isolated from shaft assembly 300, again serving to ensure power is transmitted to cathode 200 by electrode 110 and not in substantial quantities through alternate pathways. Isolation may be accomplished through the use of insulating ceramic bearings (described further below) that allow shaft assembly 300 to rotate about power delivery assembly 100, without creating a direct electrical connection therebetween. In this way, rotation of shaft assembly 300 will cause cathode 200 to rotate about magnetic field source 140 and the portion of electrode 110 that extends within cathode 200, but will not impart substantial quantities of energy to cathode 200 through shaft assembly 300 during sputtering.

To enable sputtering with RF emissions, the RF power supply 800 is preferably adapted to supply RF energy at frequencies of 1 MHz or higher. Suitable power supplies are available from suppliers including MKS of Rochester, New York, including, without limitation, the Sure Power RF Plasma Generator, model QL10513, which is a sweeping frequency RF power supply, and but one example of an RF power supply suitable for use in preferred embodiments of the present invention. Frequencies of 13MHz or higher, 25MHz or higher, 300MHz or higher, and 1 GHz may be used in various sputtering applications depending on the target material utilized, the sputtering energy available, and the desired substrate material and coating characteristics. Radio frequencies suitable for use in industrial sputtering applications are further described in 47 C.F.R. § 18 (Code of Federal Regulations of the United States of America related to industrial, scientific and medical equipment). The present invention, however, is not limited to any one frequency range, and is suitable for sputtering with frequencies from 1 MHz to well above 1 GHz, including into the microwave range. By utilizing RF power at or above 1 MHz, electrode 110 acts as an antenna transmitting RF energy into cathode 200 instead of conducting it through a brush. That energy, in combination with the magnetic field generated by magnetic field source 140 causes the target material in the outer surface of cathode 200 to eject during operation, an effect known as "sputtering."

When RF power is used, it is desirable to maintain a constant and preferably optimal load on power supply 800 in order to allow it to operate efficiently. To help ensure a consistent load on power supply 800, load matching tuner 810 may be used. Power supply 800 is electrically connected to power delivery assembly 100 through load matching tuner 810. Load matching tuner 810 may conveniently be a load matching tuner comprising capacitors and/or inductors, such as are known to those of ordinary skill in the art. Suitable tuners are available from suppliers including MKS of Rochester, New York. The MWH-100-03, 10 kW Load Matching Network, available from MKS, is one example of a load matching tuner suitable for use in certain embodiments of the present invention.

Depending on the frequencies, energy levels, target materials used, and substrate location, it may also be desirable to adjust the position of magnetic field source 140. By adjusting the mounting structure (described further below) of magnetic field source 140, magnetic field source 140 can be adjusted with respect to its proximity to the inside surface of cathode 200 by moving it closer to the inside surface of cathode 200 and away from electrode 110, or closer to electrode 110 and away from the inner surface of cathode 200. The position of magnetic field source 140 within cathode 200 may also be adjusted radially, allowing for adjustment of the angle at which material is ejected during operation, by rotating magnetic field source 140 about electrode 110.

While operation at RF frequencies enables sputtering of insulating materials, such frequencies also have the potential to induce inductive heating and magnetic fields in ferrous components. Accordingly, it is preferred, when operating at RF frequencies, that cathode 200 be electrically isolated from the other components of sputtering cathode apparatus 1 and that non-ferrous materials be utilized where feasible, except in magnetic field source 140 (described further below). It is also desirable that sputtering cathode apparatus 1 be cooled during operation. This may be accomplished by adding a cooling pump 900 adapted to pump a cooling medium such as de-ionized water into cathode 200 during operation. While a variety of pumps and cooling systems may be used, a McQuay 20 ton chiller (not illustrated) used in conjunction with a high volume water pump 900 is one suitable choice for preferred embodiments of the present invention.

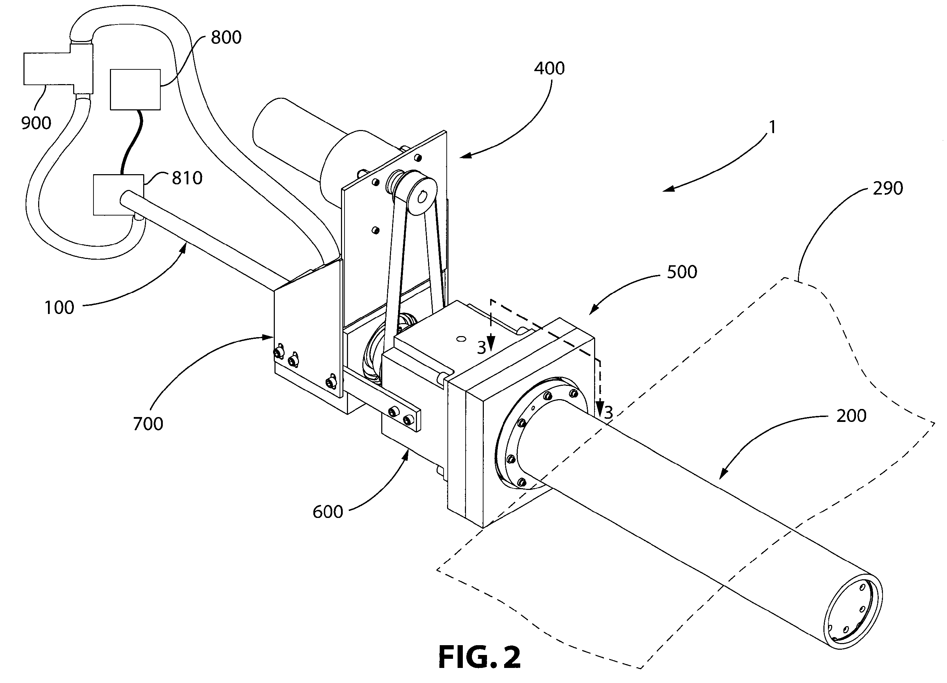

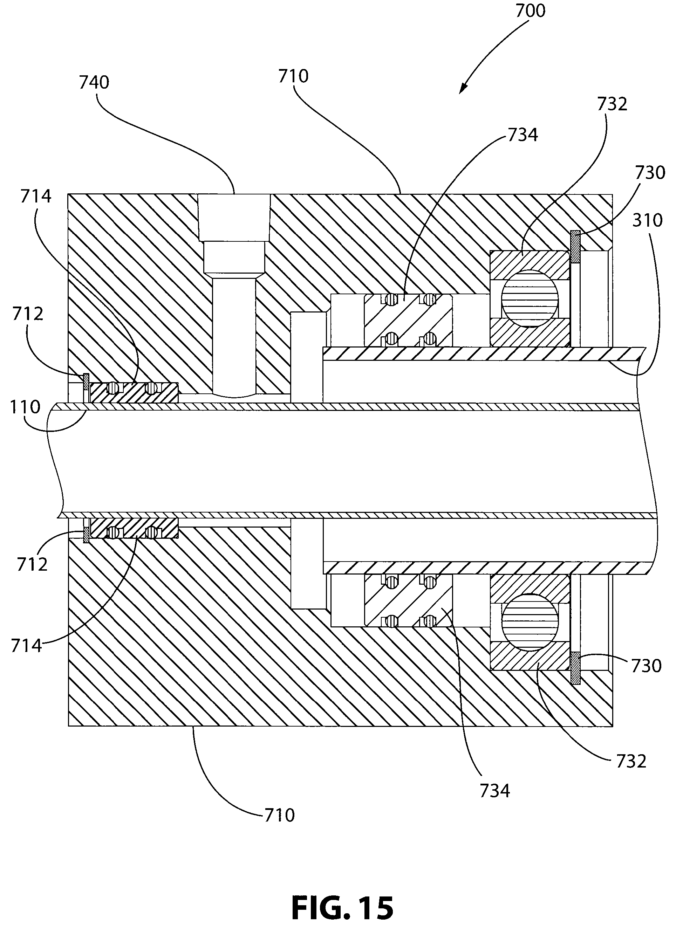

Referring again to Figs. 4-5, to facilitate cooling in this manner, electrode 110 may be substantially hollow and adapted to operatively connect to the cooling pump 900 (as shown in Fig. 2). Electrode 110 may then be adapted to deliver a cooling medium into cathode 200 by providing passages 114 in one or more locations in electrode 110. The cooling medium may then flow through electrode 110, out passages 1 14, and into cathode 200. For enhanced cooling it is preferred that the coolant material substantially fill cathode 200, without leaving any significant gaps or spaces. An insulating, slotted assembly 104 may then allow the cooling medium to escape as shaft assembly 300 and cathode 200 rotate. In this manner, the cooling pump 900 urges the cooling medium into substantially hollow electrode 110, substantially filling cathode 200, and then out through slotted assembly 104, thereby cooling power delivery assembly 100 and cathode 200, preferably continuously during operation. It will be understood that, while the direction of coolant flow described herein may be preferred, sputtering cathode apparatus 1 may function with flow in the reverse direction as well. It will also be understood that the coolant medium flows through slotted assembly 104 into shaft assembly 300, and out port 740 (shown on Fig. 15), thereby cooling shaft assembly 300 and inner housing assembly 600 and outer housing assembly 700 as well. While de-ionized water may be used, other cooling mediums are also suitable including, without limitation water/glycol mixtures known in the art.

As illustrated, electrode 110 may be formed of connecting sections including, without limitation, outer section(s) 102, interior section 111, and one or more extending sections 112. In this way, a variety of electrode lengths may be used, thereby allowing for the use of cathodes of varying lengths, by adding or removing extending sections 112 or using extending sections 112 of different lengths. Where leakage of cooling medium is not desired, flanges (e.g. first electrode flange 106 and second electrode flange 108), with a gasket (e.g. electrode flange O ring 105, which may be conveniently formed of Viton) between, and mechanical fasteners 109 (preferably of non-ferrous metal), may be used to connect sections of electrode 110. Where leakage is not as much of a concern, a simple friction fitting may be used, as is shown between interior section 111 and extending section 112. As illustrated magnetic field source 140 (described further below) serves to keep interior section 111 and extending section 112 from separating during operation, but other means of securing, including without limitation set screws, mechanical fasteners, and friction-fitting may also be used if desired.

Passages 1 14 are preferably at the outer end of final extending section 112, but may be placed elsewhere on electrode 110 either instead of, or in addition to, at the outer end of final extending section 112. Insulating, and preferably ceramic, end piece bushing 116 provides support for electrode 110 while allowing cathode 200 to rotate about it. ULTEM is one suitable material for end piece bushing 116.

Electrode 110 may be formed of any material suitable for use in transmitting RF energy including, without limitation brass, and will preferably be a non-ferrous material to aid in minimizing undesirable magnetic effects, as should mechanical fasteners 109, which may suitably be 304 stainless steel.

Magnetic field source 140 may attach to electrode 110 as illustrated with lower clamping members 146 and upper clamping members 144. By using larger upper clamping members 144, or other adjustment means known to those of skill in the art, the proximity of magnetic field source 140 to the inside surface of cathode 200 may be adjusted. Magnetic field source 140 may also be adjusted radially by loosening upper clamping member 144 and lower clamping member 146 and rotating magnetic field source 140 about electrode 110, before re-tightening. Magnetic field source 140 may conveniently comprise carrier 148 and magnets 142, with securing members 149 securing magnets 142 in place. While the precise magnets used will vary based on the sputtering application (as is understood in the art), a plurality of 12.7 mm x 12.7 mm x 6.35 mm (1/2" x 1/2" x 1/4") magnets of grade N42, stacked two-high to form 12.7 mm (1/2") cubes would be appropriate choices for magnets 142 for typical applications. By way of example, and without limitation, approximately 240 such magnets 142 arranged in three rows could be used with a cathode 200 of approximately 55.88 cm (approximately 22 inches). Such magnets are available from a host of suppliers such as K&J Magnetics, Inc.

Carrier 148, upper clamping members 144, lower clamping members 146, securing members 149 and any fasteners used to secure those components, should preferably be of non-ferrous materials. While insulating materials such as PVC can be utilized, non-ferrous thermally conductive materials such as aluminum are preferred as they allow for better cooling and heat transfer.

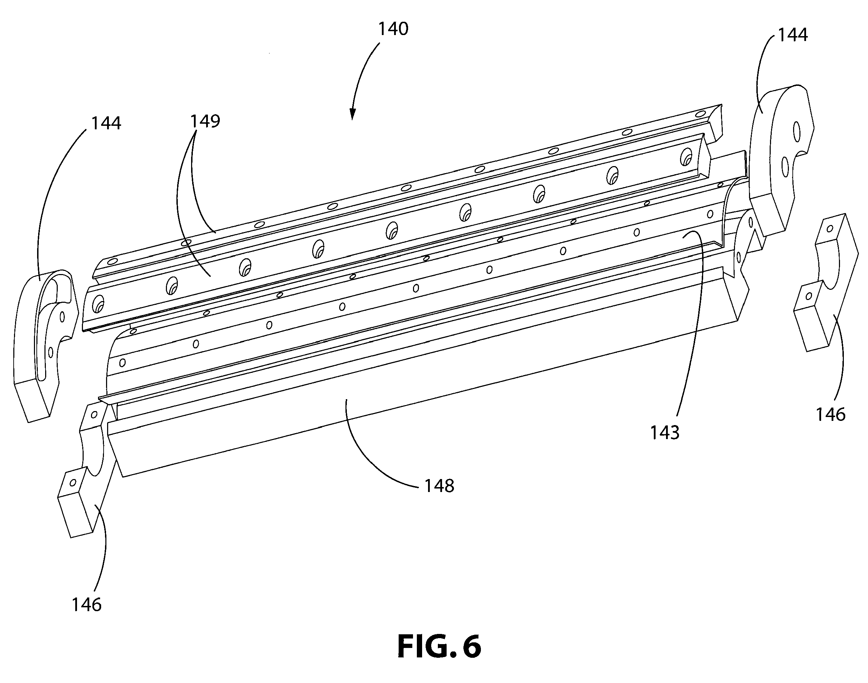

Fig. 6 illustrates an exploded view of magnetic field source 140, without magnets 142 installed. As can be seen in the illustration, magnetic shunt 143 is positioned beneath magnets 142 (when installed). Magnetic shunt 143, which may conveniently be 416 stainless steel, acts to reduce the likelihood of sputtering below magnetic field source 140 by shunting the magnetic field generated by magnets 142 (when installed).

As illustrated, electrode 110 is not in direct electrical contact with cathode 200. In such embodiments, RF energy is transmitted from electrode 110 to cathode 200, as opposed to being transferred by conduction through direct contact. Where conductive transfer is also desired, brushes (not illustrated) may be used to create a direct electrical connection between electrode 110 and cathode 200 as well. However, the use of RF emissions means that such brushes are not required as they are with lower frequencies, at which direct electrical contact is needed. A variety of suitable brushes are known to those of ordinary skill in the art.

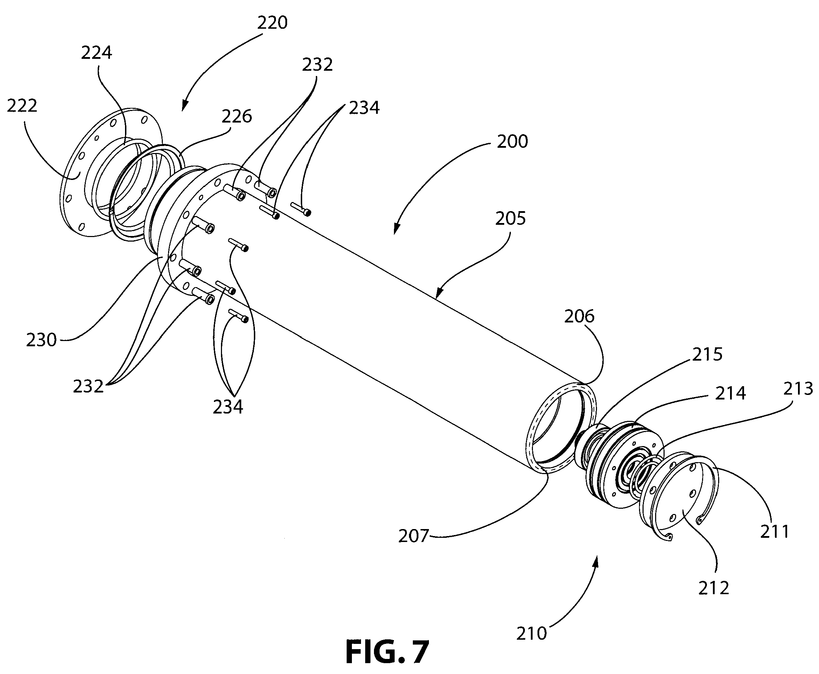

Cathode assembly 200 is shown in further detail on Fig. 7. Cathode 200 comprises cathode flange assembly 220, sacrificial target 205, and cathode end cap assembly 210. Sacrificial target 205 may be made entirely of the target material to be sputtered, or may comprise target material in its outer surface 206 and a backing tube 207 formed of other materials such as, for example, copper. Cathodes 200 with sacrificial targets having different target materials, suitable for use in preferred embodiments of the present invention, are available from suppliers such as Soleras Ltd. of Biddeford Maine.

Sacrificial target 205 is substantially hollow, and is adapted such that magnetic field source 140 will fit within sacrificial target 205, along with at least a portion of electrode 110, which preferably extends at least to the center point of the length of sacrificial target 205, thereby delivering RF power centrally within cathode assembly 200, which is preferred.

Cathode flange assembly 220 comprises cathode flange 230, spiral cathode retaining ring 226, cathode flange O ring 224, and cathode flange insulator 222. Both cathode flange O ring 224 and cathode flange insulator 222 may conveniently be formed of Viton. Cathode flange 230, which may conveniently be formed of aluminum, fits over sacrificial target 205. Spiral cathode retaining ring 226 secures cathode flange 230. Tightening cathode flange fasteners 234 allows cathode 200 to operatively connect to shaft assembly 300 such that rotation of shaft assembly 300 rotates cathode assembly 200. Cathode flange insulator 222 (which may conveniently formed of a material with high dielectric resistance such as ULTEM) electrically isolates cathode assembly 200 from shaft assembly 300, which is desirable when dealing with high frequency RF power, for reasons including because it reduces the likelihood of arcing. Cathode flange fasteners 234 (which may be conveniently formed of 304 stainless steel) form the mechanical connection, but do so through cathode flange fastener insulators 232 (which may also be formed of ULTEM). The purpose is to provide electrical isolation by ensuring that cathode flange fasteners 234 are not in conductive contact with cathode assembly 200, thereby helping ensure that power transfers to cathode assembly 200 almost exclusively through power delivery assembly 100 and not secondarily through shaft assembly 300.

Cathode end cap assembly 210 serves two purposes. First, it provides a seal that prevents leakage of the cooling medium. Second, it provides support for the end of electrode 110. Cathode end cap assembly 210 comprises cathode end cap retaining ring 211 (which may conveniently be formed of 304 stainless steel) and cathode end cap plate 212, which is also preferably formed of a non-ferrous material such as aluminum. Insulating cathode end plate bearing 215, which may conveniently be formed of a ceramic material such as Zirconia Oxide, supports the end piece bushing 116 and allows cathode 200 to rotate about it. Insulating cathode end plate bearing 215 is held within cathode end plate plug 214, which seals against the inner surface of sacrificial target 205 to prevent leakage of the cooling medium. Cathode end plate plug 214 may be attached to cathode end cap plate 212 with mechanical fasteners (not illustrated) and is sealed with cathode end plate O rings 213, which may conveniently be formed of Viton.

Given the ability of apparatus 1 to operate at high frequency RF energy levels, a variety of materials may be used for target material in outer surface 206 of sacrificial target 205, including, without limitation, oxides and ceramics.

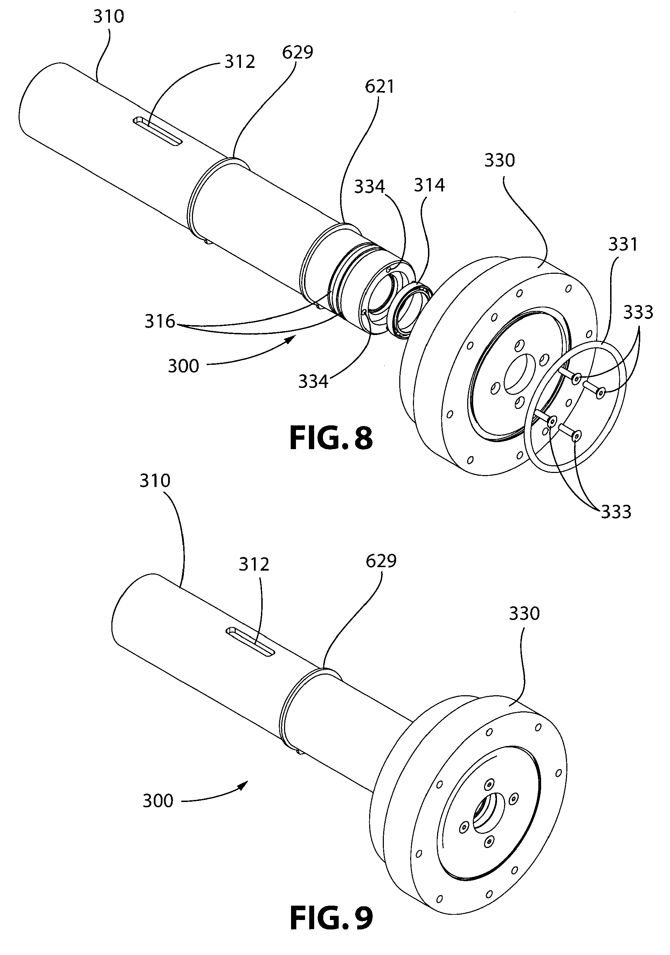

Shaft assembly 300 is shown in greater detail in Figs. 8-9. As is noted above, shaft assembly 300 connects to cathode 200 and provides the force to turn cathode 200 during operation. Shaft assembly 300 is also preferably formed of non-ferrous materials. More specifically, shaft assembly 300 comprises shaft 310 and shaft flange 330. Shaft 310 is preferably brass, but may also be formed of other non-ferrous materials. Shaft flange 330 is also non-ferrous, and may conveniently be formed of aluminum. Shaft flange 330 accepts cathode flange fasteners 234 from cathode assembly 200 (shown in Fig. 7), with shaft flange O ring 331 (which may conveniently be formed of Viton) forming a seal that resists leakage during operation, as do shaft O rings 316. Shaft 310 may conveniently be attached to shaft flange 330 with mechanical fasteners 333 (preferably 304 stainless steel fasteners) that are received into receptacles 334 in shaft 310. Non-conductive shaft bearing 314 (preferably another Zirconia Oxide ceramic bearing) is adapted to accept slotted assembly 104 (shown of Figs. 4-5) and thereby support electrode 110 during operation. In this way, shaft bearing 314 and slotted assembly 104 form a non-conductive ceramic bearing in at least partial contact with electrode 110, and allows the cooling medium travelling through electrode 110 and into cathode 200, to flow into the body of shaft assembly 300, outside of electrode 110. It will be understood by those of ordinary skill in the art that, depending on the diameters of electrode 110 and shaft bearing 314, instead of open slots as illustrated, holes or channels through a solid member (not illustrated) may also be used to allow the return of cooling medium while shaft assembly 300 rotates about electrode 110. As shaft assembly 300 rotates around electrode 110, slotted assembly 104 does not need to rotate. Instead, slotted assembly 104 need only provide a passage for the cooling medium to return out of cathode 200. The supporting connection between electrode 110 and shaft 310, regardless of its mechanical configuration, however, is preferably non-conductive.

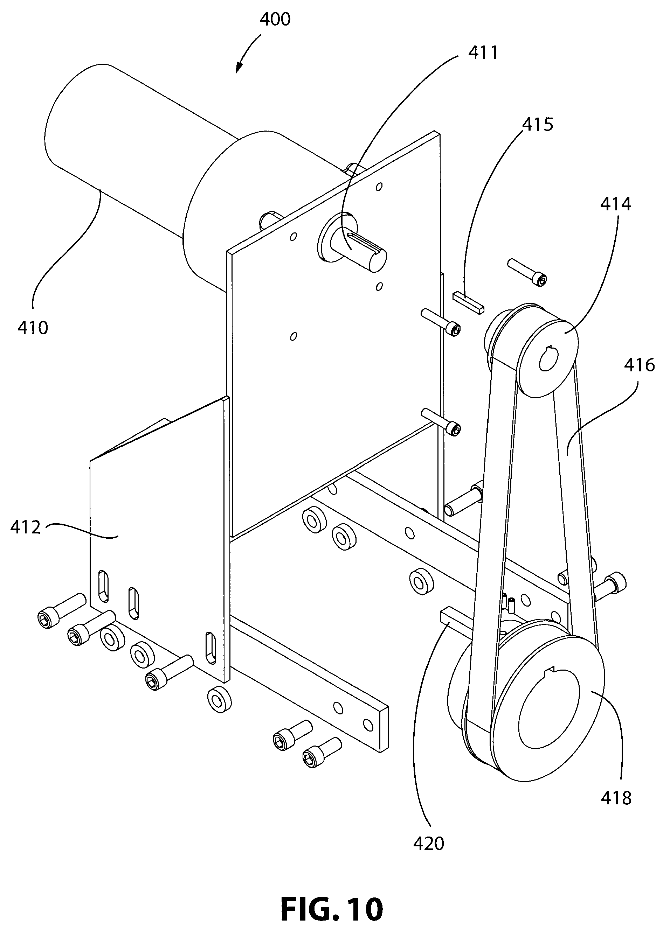

Key slot 312 is integrated into shaft 310 to allow for attachment of a lower pulley 418 via lower pulley key 420, as is shown in Fig. 10. Drive motor assembly 400 comprises drive motor 410 which is preferably capable of operating at different speeds. Using an AC motor for drive motor 410 is preferred as it can assist in reducing interference issues. Drive motor 410 connects to motor bracket 412 (also preferably formed on non-ferrous material such as aluminum) with traditional mechanical fasteners. Shaft 411 of drive motor 410 extends through motor bracket 412 and connects to upper pulley 414 with upper pulley key 415. Upper pulley 414 and upper pulley key 415 may conveniently be formed of 304 stainless steel. Belt 416 then drives lower pulley 418 (which may conveniently be formed of aluminum), which surrounds shaft 310, and is secured with lower pulley key 420 (which may also conveniently be formed of 304 stainless steel). In this way, drive motor 410 drives shaft assembly 300. Motor bracket 412 attaches to outer housing assembly 700 and inner housing assembly 600 via traditional (and preferably non-ferrous) mechanical fasteners, as shown in Fig. 2. As is also shown in Fig. 2, lower pulley 418 is preferably positioned between inner housing assembly 600 and outer housing assembly 700.

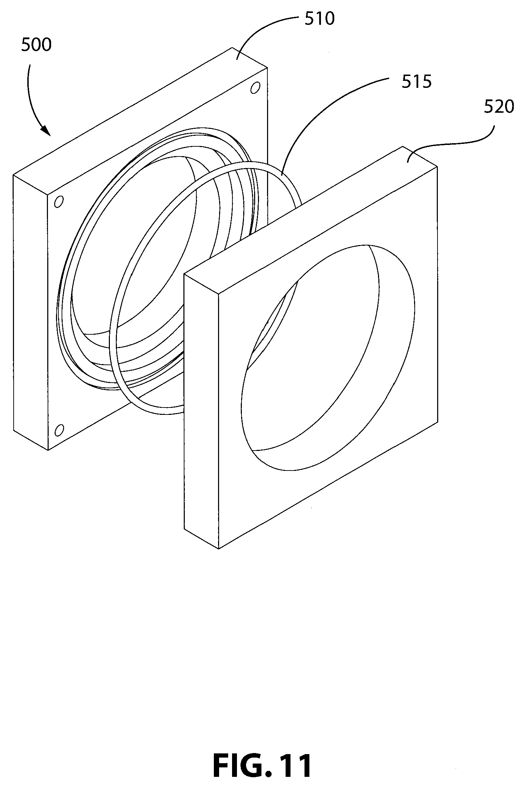

As has been discussed, mounting plate assembly 500 is attached to the wall 512 of the substantially evacuated chamber (not illustrated). Mounting plate assembly 500 connects to inner housing assembly 600 (as shown in Figs. 2-3) through preferably non-ferrous mechanical fasteners (not illustrated). Mounting plate assembly 500 supports shaft flange 330 and cathode flange 230 of shaft assembly 300 and cathode 200 respectively. Referring to Figs. 3 and11, mounting plate assembly 500 comprises inner mounting block plate 520, mounting block O ring 515 (which may conveniently be formed of Viton) and outer mounting block plate 510. Inner mounting block plate 520 and outer mounting block plate 510 are preferably constructed of stainless steel with inner mounting block plate 520 being welded or otherwise fixedly attached to the inside of wall 530 of the substantially evacuated chamber (not illustrated). Outer mounting block plate 510 is preferably fixedly attached to the outside of wall 530 with mechanical fasteners (not illustrated), outer mounting plate O ring 515 (which may conveniently be formed of Viton) helping improve the seal between wall 530 and outer plate 510. The opening of inner mounting block plate 520 is adapted to accept cathode flange 230 and the smaller opening of inner mounting block plate 520 is adapted to accept shaft flange 330, each with sufficient clearance to allow movement and prevent arcing.

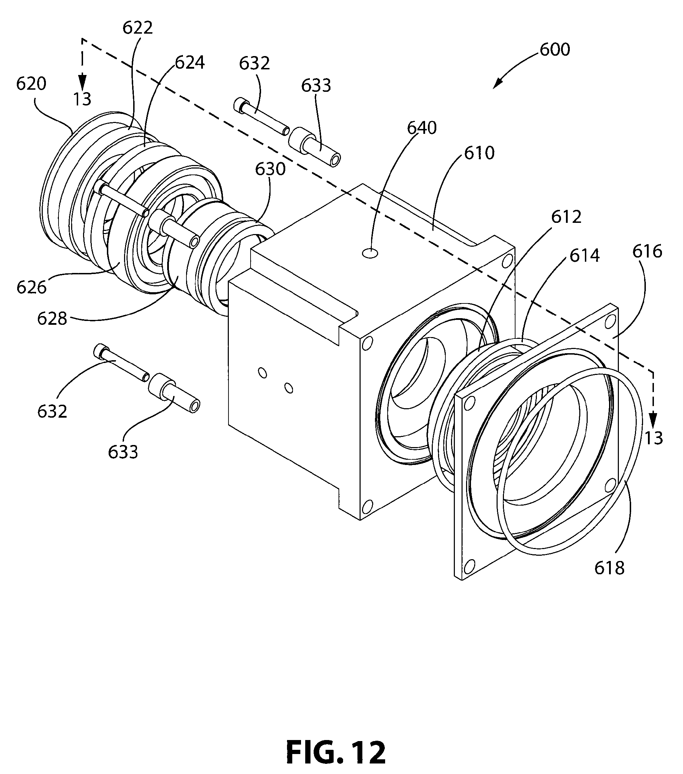

Figs. 12-13 illustrate inner housing assembly 600. Inner housing assembly 600 comprises inner housing body 610, which is preferably formed of aluminum and is attached to mounting plage assembly 500 and inner housing insulator 616 (which may conveniently be formed of Ultem) with fasteners 632 (which pass through inner housing fastener insulators 633, also conveniently formed of Ultem), thereby electrically isolating inner housing assembly 600 from mounting plage assembly 500. As has been previously discussed, inner housing insulator 616 and inner housing fastener insulators 633 are adapted to promote electrical isolation which is desirable for high frequency and high voltage operation. First inner housing O ring 618 and second inner housing O ring 614 (both of which may conveniently be formed of Viton) help prevent leaks when apparatus 1 is operating. First inner housing bearing 612 (preferably an insulating ceramic bearing formed of a material such as Zirconia Oxide) provides support for shaft assembly 300 while turning, without creating an electrical connection between inner housing assembly 600 and shaft assembly 300. First inner housing bearing 612 is secured by first inner housing snap ring 621, which may conveniently be formed of 304 stainless steel.

Inner housing seal 628 may conveniently be a rotating water pump shaft seal such as a John Crane shaft seal, type 21, and is adapted to operate in conjunction with race 630 to reduce or eliminate vacuum leaks, while still allowing shaft 310 to rotate. Second inner housing bearing 626 (which may also be an insulating ceramic bearing formed of a material such as Zirconia Oxide) further supports shaft assembly 300 without creating a direct electrical connection to inner housing body 610, and is held in place by second inner housing snap ring 629, second inner housing bearing seal 622, and spacer 624. First inner housing opening 640 and second inner housing opening 642 allow for monitoring for vacuum leaks, and possibly the use of a secondary vacuum pump to compensate for small vacuum leaks, which will occur over time as inner housing seal 628 wears. Inner housing oil seal retaining ring 620 (which may conveniently be formed of 304 stainless steel) acting to prevent leakage.

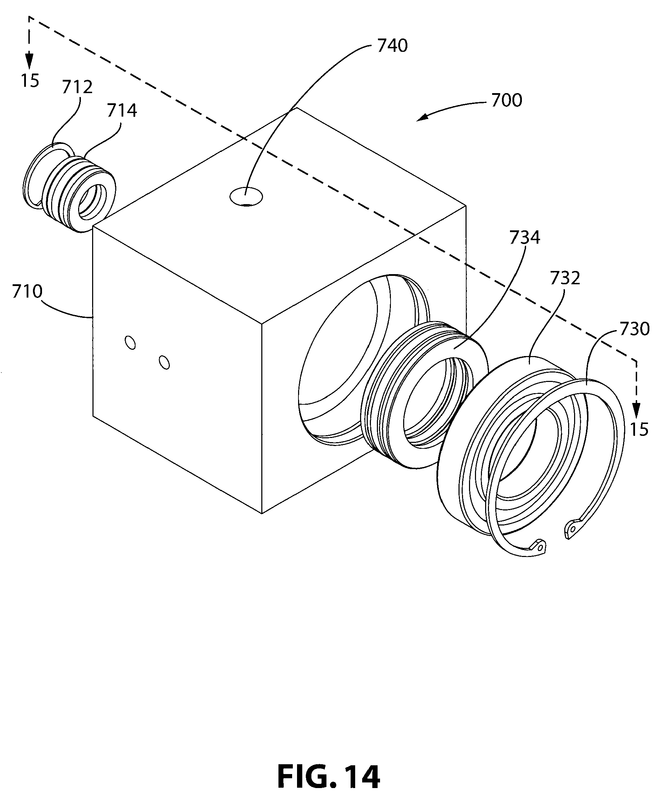

Figs. 14-15 illustrate outer housing assembly 700, which supports shaft assembly 300 and power delivery assembly 100 and is attached to inner housing assembly 600 via motor bracket 412 (as shown in Fig. 2). Outer housing assembly 700 comprises outer housing body 710, preferably formed of aluminum. Outer housing bearing 732 is secured into outer housing body 710 with outer housing bearing retaining ring 730, and supports shaft assembly 300 while also providing electrical isolation between shaft assembly 300 and outer housing body 710. Outer housing bearing 732 is also preferably an insulating ceramic bearing formed of a material such as Zirconia Oxide. As cooling medium flows out the end of shaft assembly 300, first outer housing seal 734 prevents it from flowing back to outer housing bearing 732, while still allowing shaft 310 to turn. Instead, the medium flows or is pumped out port 740. Second outer housing seal 714, which is secured by second outer housing seal retaining ring 712 is adapted to further support power delivery assembly 100 and also to provide electrical isolation between power delivery assembly 100 and outer housing body 710, while also preventing leakage of returned cooling medium, which exits out the back of shaft assembly 300 and out port 740, where it may be captured, cooled, and recycled. Electrode 110 extends out through second outer housing seal 714, at which point it may be electrically connected to the RF power supply 800, as is well understood in the art.

Also disclosed herein is a method of depositing material with a rotating cylindrical magnetron sputtering cathode apparatus comprising a radio frequency power supply, a power delivery assembly, a rotating cathode, a shaft and a drive motor. Apparatus 1, described in detail above, is one suitable apparatus for use in connection with this method, but, as will be understood, it is not necessary to include all of the features of apparatus 1 in order to utilize the method. As has been described, power delivery assembly 100 comprises a magnetic field source 140 positioned within cathode 200 and an electrode 110 extending within cathode 200. The outer surface 206 of the sacrificial target 205 of cathode 200 comprises a target material. Electrode 110 is electrically isolated from shaft assembly 300, and shaft assembly 300 is generally coaxial with cathode 200. To facilitate RF operation, electrode 110 and said shaft assembly 300 are formed from non-ferrous materials.

Given an apparatus with the above characteristics, material may be deposited by causing the power supply 800 to supply radio frequency energy at frequencies of 1 MHz or higher, through electrode 110. Cathode 200 is then caused to rotate about magnetic field source 140. By positioning a substrate (meaning an object on which material is to be deposited) 290 proximate to the outside surface of cathode 200, radio frequency energy from the power source, transmitted through the electrode, in combination with the magnetic field generated by magnetic field source 140 will cause particles of target material from outer surface 206 to eject onto substrate 290.

Alternative frequencies may be used with this method, including frequencies of 13MHz or higher, 25MHz or higher, 300MHz or higher, and 1 GHz or higher (with no set upper limit). When frequencies above 1MHz are used in conjunction with this method, it is not necessary that electrode 1 10 be in direct electrical contact with cathode 200 as the RF energy will be transmitted if not conducted between the two. The utilization of higher frequency RF emissions in this method permits sputtering of target materials which are un-doped insulating materials substantially free of conducting materials. In this way, with an apparatus 1 comprising a radio frequency power supply 800 and a cylindrical rotating cathode 200 having an outer surface 206 of sacrificial target material comprising an oxide such as, without limitation, Zinc Oxide or Aluminum Oxide, can sputter the oxide directly without requiring doping. As has been described, this can be accomplished by causing power supply 800 to supply radio frequency energy at frequencies of 1 MHz or higher (with frequencies above 13MHz, 25MHz, 300MHz, and 1 GHz all being suitable in different applications, causing said cathode 200 to rotate, and positioning substrate 290 proximate to the outside surface of cathode 200, whereby the radio frequency energy and magnetic field cause cathode 200 to eject particles onto substrate 290.

The above-described preferred embodiments are intended to be exemplary, and not limiting. Other variations and embodiments of the apparatus and methods of the present invention will be apparent to those of ordinary skill in the art in light of this specification, all of which are within the scope of the present invention as claimed.

Further particular and preferred aspects of the invention are set out in the accompanying independent and dependent clauses. Features of the dependent clauses may be combined with those of the independent clauses and independent claims as appropriate and in combinations other than those explicitly set out in the clauses and claims.
1. A method of depositing material with a rotating cylindrical magnetron sputtering cathode apparatus comprising a radio frequency power supply, a power delivery assembly, a rotating cathode, a shaft and a drive motor wherein
   said power delivery assembly comprises a magnetic field source positioned within said cathode and an electrode extending within said cathode;
   said electrode is electrically isolated from said shaft;
   the outer surface of said cathode comprises a target material formed of insulating materials and substantially free of conductive materials;
   said method comprising the steps of
   causing said power supply to supply radio frequency energy at frequencies of I MHz or higher;
   causing said cathode to rotate about said magnetic field source; and positioning a substrate proximate to outside surface of said cathode;
   whereby said radio frequency energy a causes said rotating cathode to eject particles from said target material onto said substrate.
2. The method of clause 1 wherein said electrode is not in direct electrical contact with said cathode
3. The method of clause 1 wherein said power supply is adapted to supply radio frequency energy at frequencies of 13MHz or higher.
4. The method of clause 3 wherein said power supply is adapted to supply radio frequency energy at frequencies of 25MHz or higher.
5. The method of clause 4 wherein said power supply is adapted to supply radio frequency energy at frequencies of 300MHz or higher.
6. The method of clause 5 wherein said power supply is adapted to supply radio frequency energy at frequencies of 1MHz or higher.
7. A method of depositing material with a rotating cylindrical magnetron sputtering cathode apparatus comprising a radio frequency power supply and a cylindrical rotating cathode, wherein the outer surface of said rotating cathode comprises a target material formed of an oxide;
   said method comprising the steps of
   causing said power supply to supply radio frequency energy at frequencies of 1 MHz or higher;
   causing said cathode to rotate; and
   positioning a substrate proximate to said outside surface of said cathode;
   whereby said radio frequency energy causes said cathode to eject particles from said target material onto said substrate.
8. The method of clause 7 wherein said power supply is adapted to supply radio frequency energy at frequencies of 13GHz or higher.
9. The method of clause 8 wherein said power supply is adapted to supply radio frequency energy at frequencies of 25MHz or higher.
10. The method of clause 9 wherein said power supply is adapted to supply radio frequency energy at frequencies of 300MHz or higher.
11. The method of clause 10 wherein said power supply is adapted to supply radio frequency energy at frequencies of 1 GHz or higher.

## Claims

1. A rotating magnetron sputtering cathode apparatus (1) comprising a radio frequency power supply (800), a power delivery assembly (100), a cylindrical rotating cathode (200), a shaft (300) and a drive motor (400) wherein
said power delivery assembly comprises a magnetic field source (140) positioned within said cathode and an electrode (110) extending within said cathode; the outer surface (206) of said cathode comprises a target material (205); said electrode is arranged to be electrically isolated from said shaft;
said electrode and said shaft are formed from non-ferrous materials;
said shaft is arranged to be generally coaxial with said cathode and arranged to be mechanically connected to said cathode such that said shaft and said cathode are electrically isolated and rotation of said shaft causes said cathode to rotate about said magnetic field source and a portion of said electrode;
said drive motor is adapted to rotate said shaft;
said power supply is adapted to supply radio frequency energy at frequencies of 1GHz or higher; and
said electrode is arranged to be electrically connected to said power supply.

2. The apparatus of claim 1 wherein said electrode (110) is arranged not to be in direct electrical contact with said cathode (200).

3. The apparatus of claim 1 wherein said power supply (800) is adapted to supply radio frequency energy at frequencies of 13MHz or higher.

4. The apparatus of claim 3 wherein said power supply is adapted to supply radio frequency energy at frequencies of 25MHz or higher.

5. The apparatus of claim 4 wherein said power supply is adapted to supply radio frequency energy at frequencies of 300MHz or higher.

6. The apparatus of claim 5 wherein said power supply is adapted to supply radio frequency energy at frequencies of 1GHz or higher.

7. The apparatus of claim 1 wherein said target material (205) consists of an insulating material substantially free of conducting materials.

8. The apparatus of claim 1 wherein the position of said magnetic field source (140) within said cathode (200) is adjustable with respect to its proximity to the inside surface of said cathode.

9. The apparatus of claim 1 wherein the position of said magnetic field source within said cathode is radially adjustable about said electrode (110).

10. The apparatus of claim 1 further comprising a cooling pump (900) adapted to pump a cooling medium wherein
said electrode is substantially hollow and adapted to operatively connect to said cooling pump;
said electrode is adapted to deliver a cooling medium into said cathode from said cooling pump; and
said shaft and said power delivery assembly further comprise an insulating, channelled bearing assembly adapted to allow said cooling medium to flow out of said cathode; said cooling medium being arranged to flow into said hollow electrode and through said channelled bearing assembly, thereby cooling said power delivery assembly and said cathode.

11. The apparatus of claim 10 wherein said channelled bearing assembly comprises a non-conductive ceramic bearing (314) in at least partial contact with said electrode.

12. A method of depositing material with a rotating cylindrical magnetron sputtering cathode apparatus (1) comprising a radio frequency power supply (800), a power delivery assembly (100), a rotating cathode (200), a shaft (300) and a drive motor (400) wherein
said power delivery assembly comprises a magnetic field source (140) positioned within said cathode and an electrode, (110) extending within said cathode; the outer surface (206) of said cathode comprises a target material (205);
said electrode is arranged to be electrically isolated from said shaft;
said shaft is arranged to be generally coaxial with said cathode; and
said electrode and said shaft are formed from non-ferrous materials;
said method comprising the steps of
supplying radio frequency energy at frequencies of 1 MHz or higher to the electrode;
rotating the cathode about said magnetic field source; and positioning a substrate (290)
proximate to said outside surface of said cathode;
whereby said radio frequency energy causes particles of said target material to eject onto said substrate.

13. The method of claim 12 wherein said electrode (110) is arranged not to be in direct electrical contact with said cathode (200).

14. The method of claim 12 wherein said power supply (800) is adapted to supply radio frequency energy at frequencies of 13MHz or higher.

15. The method of claim 14 wherein said power supply is adapted to supply radio frequency energy at frequencies of 25MHz or higher.

16. The method of claim 15 wherein said power supply is adapted to supply radio frequency energy at frequencies of 300MHz or higher.

17. The method of claim 16 wherein said power supply is adapted to supply radio frequency energy at frequencies of 1 GHz or higher.

18. The method of claim 12 wherein said target material is formed of insulating materials and is substantially free of conducting materials.

19. The method of claim 12, wherein said target material (205) is formed of an oxide.

## Patentansprüche

1. Magnetronsputtervorrichtung (1) mit rotierender Kathode, umfassend eine Radiofrequenz-Energieversorgung (800), eine Energiezuführbaugruppe (100), eine zylindrische rotierende Kathode (200), eine Welle (300) und einen Antriebsmotor (400), wobei
die Energiezuführbaugruppe eine Magnetfeldquelle (140) umfasst, die innerhalb der Kathode angeordnet ist, und eine Elektrode (110), die innerhalb der Kathode verläuft;
die Außenoberfläche (206) der Kathode ein Zielmaterial (205) umfasst;
die Elektrode dafür gestaltet ist, von der Welle elektrisch isoliert zu sein;
die Elektrode und die Welle aus Nichteisenmaterialien bestehen;
die Welle dafür gestaltet ist, allgemein koaxial mit der Kathode zu sein, und dafür gestaltet ist, mechanisch mit der Kathode verbunden zu sein, so dass die Welle und die Kathode elektrisch isoliert sind und Drehung der Welle bewirkt, dass sich die Kathode um die Magnetfeldquelle und einen Teil der Elektrode dreht;
der Antriebsmotor dafür ausgelegt ist, die Welle zu drehen;
die Energieversorgung dafür ausgelegt ist, Radiofrequenzenergie mit Frequenzen von 1 MHz oder höher zu liefern; und
die Elektrode dafür gestaltet ist, mit der Energieversorgung elektrisch verbunden zu sein.

2. Vorrichtung gemäß Anspruch 1, wobei die Elektrode (110) dafür gestaltet ist, nicht in direktem elektrischem Kontakt mit der Kathode (200) zu stehen.

3. Vorrichtung gemäß Anspruch 1, wobei die Energieversorgung (800) dafür ausgelegt ist, Radiofrequenzenergie mit Frequenzen von 13 MHz oder höher zu liefern.

4. Vorrichtung gemäß Anspruch 3, wobei die Energieversorgung dafür ausgelegt ist, Radiofrequenzenergie mit Frequenzen von 25 MHz oder höher zu liefern.

5. Vorrichtung gemäß Anspruch 4, wobei die Energieversorgung dafür ausgelegt ist, Radiofrequenzenergie mit Frequenzen von 300 MHz oder höher zu liefern.

6. Vorrichtung gemäß Anspruch 5, wobei die Energieversorgung dafür ausgelegt ist, Radiofrequenzenergie mit Frequenzen von 1 GHz oder höher zu liefern.

7. Vorrichtung gemäß Anspruch 1, wobei das Zielmaterial (205) aus einem isolierenden Material besteht, das im Wesentlichen frei von leitfähigen Materialien ist.

8. Vorrichtung gemäß Anspruch 1, wobei die Position der Magnetfeldquelle (140) innerhalb der Kathode (200) bezüglich ihrer Nähe zu der Innenoberfläche der Kathode einstellbar ist.

9. Vorrichtung gemäß Anspruch 1, wobei die Position der Magnetfeldquelle innerhalb der Kathode radial um die Elektrode (110) einstellbar ist.

10. Vorrichtung gemäß Anspruch 1, ferner umfassend eine Kühlpumpe (900), die dafür ausgelegt ist, ein Kühlmedium zu pumpen, wobei
die Elektrode im Wesentlichen hohl ist und dafür ausgelegt ist, operativ mit der Kühlpumpe verbunden zu sein;
die Elektrode dafür ausgelegt ist, ein Kühlmedium von der Kühlpumpe in die Kathode zu liefern; und
die Welle und die Energieversorgungsbaugruppe ferner eine isolierende, mit Kanälen versehene Lagerbaugruppe umfassen, die dafür ausgelegt ist, zu erlauben, dass das Kühlmedium aus der Kathode ausfließt;
das Kühlmedium dafür ausgelegt ist, in die hohle Elektrode und durch die mit Kanälen versehene Lagerbaugruppe zu fließen, um die Energieversorgungsbaugruppe und die Kathode zu kühlen.

11. Vorrichtung gemäß Anspruch 10, wobei die mit Kanälen versehene Lagerbaugruppe ein nicht leitfähiges keramisches Lager (314) umfasst, das wenigstens teilweise in Kontakt mit der Elektrode steht.

12. Verfahren zum Abscheiden von Material mit einer Magnetronsputtervorrichtung (1) mit rotierender zylindrischer Kathode, umfassend eine Radiofrequenz-Energieversorgung (800), eine Energiezuführbaugruppe (100), eine rotierende Kathode (200), eine Welle (300) und einen Antriebsmotor (400), wobei
die Energiezuführbaugruppe eine Magnetfeldquelle (140) umfasst, die innerhalb der Kathode angeordnet ist, und eine Elektrode (110), die innerhalb der Kathode verläuft;
die Außenoberfläche (206) der Kathode ein Zielmaterial (205) umfasst;
die Elektrode dafür gestaltet ist, von der Welle elektrisch isoliert zu sein;
die Welle dafür gestaltet ist, allgemein koaxial mit der Kathode zu sein; und
die Elektrode und die Welle aus Nichteisenmaterialien bestehen;
wobei das Verfahren die Schritte umfasst:
Zuführen von Radiofrequenzenergie mit Frequenzen von 1 MHz oder höher zu der Elektrode;
Drehen der Kathode um die Magnetfeldquelle; und
Anordnen eines Substrats (290) nahe der Außenoberfläche der Kathode;
wobei die Radiofrequenzenergie bewirkt, dass Partikel des Zielmaterials auf das Substrat ausgestoßen werden.

13. Verfahren gemäß Anspruch 12, wobei die Elektrode (110) dafür gestaltet ist, nicht in direktem elektrischem Kontakt mit der Kathode (200) zu stehen.

14. Verfahren gemäß Anspruch 12, wobei die Energieversorgung (800) dafür ausgelegt ist, Radiofrequenzenergie mit Frequenzen von 13 MHz oder höher zu liefern.

15. Verfahren gemäß Anspruch 14, wobei die Energieversorgung dafür ausgelegt ist, Radiofrequenzenergie mit Frequenzen von 25 MHz oder höher zu liefern.

16. Verfahren gemäß Anspruch 15, wobei die Energieversorgung dafür ausgelegt ist, Radiofrequenzenergie mit Frequenzen von 300 MHz oder höher zu liefern.

17. Verfahren gemäß Anspruch 16, wobei die Energieversorgung dafür ausgelegt ist, Radiofrequenzenergie mit Frequenzen von 1 GHz oder höher zu liefern.

18. Verfahren gemäß Anspruch 12, wobei das Zielmaterial aus isolierenden Materialen besteht und im Wesentlichen frei von leitfähigen Materialien ist.

19. Verfahren gemäß Anspruch 12, wobei das Zielmaterial (205) aus einem Oxid besteht.

## Revendications

1. Appareil à cathode de pulvérisation magnétron rotative (1) comprenant une alimentation électrique radiofréquence (800), un ensemble de délivrance de puissance (100), une cathode cylindrique rotative (200), un arbre (300) et un moteur d'entraînement (400), dans lequel
ledit ensemble de délivrance de puissance comprend une source de champ magnétique (140) positionnée à l'intérieur de ladite cathode et une électrode (110) s'étendant à l'intérieur de ladite cathode ;
la surface extérieure (206) de ladite cathode comprend un matériau cible (205) ;
ladite électrode est agencée pour être isolée électriquement dudit arbre ;
ladite électrode et ledit arbre sont formés à partir de matériaux non ferreux ;
ledit arbre est agencé pour être généralement coaxial avec ladite cathode et agencé pour être relié mécaniquement à ladite cathode de telle sorte que ledit arbre et ladite cathode sont isolés électriquement et une rotation dudit arbre fait tourner ladite cathode autour de ladite source de champ magnétique et d'une partie de ladite électrode ;
ledit moteur d'entraînement est adapté pour faire tourner ledit arbre ;
ladite alimentation électrique est adaptée pour fournir de l'énergie radiofréquence à des fréquences de 1 MHz ou plus ; et
ladite électrode est agencée pour être reliée électriquement à ladite alimentation électrique.

2. Appareil de la revendication 1 dans lequel ladite électrode (110) est agencée pour ne pas être en contact électrique direct avec ladite cathode (200).

3. Appareil de la revendication 1 dans lequel ladite alimentation électrique (800) est adaptée pour fournir de l'énergie radiofréquence à des fréquences de 13 MHz ou plus.

4. Appareil de la revendication 3 dans lequel ladite alimentation électrique est adaptée pour fournir de l'énergie radiofréquence à des fréquences de 25 MHz ou plus.

5. Appareil de la revendication 4 dans lequel ladite alimentation électrique est adaptée pour fournir de l'énergie radiofréquence à des fréquences de 300 MHz ou plus.

6. Appareil de la revendication 5 dans lequel ladite alimentation électrique est adaptée pour fournir de l'énergie radiofréquence à des fréquences de 1 GHz ou plus.

7. Appareil de la revendication 1 dans lequel ledit matériau cible (205) consiste en un matériau isolant sensiblement dépourvu de matériaux conducteurs.

8. Appareil de la revendication 1 dans lequel la position de ladite source de champ magnétique (140) à l'intérieur de ladite cathode (200) est ajustable par rapport à sa proximité de la surface intérieure de ladite cathode.

9. Appareil de la revendication 1 dans lequel la position de ladite source de champ magnétique à l'intérieur de ladite cathode est ajustable radialement autour de ladite électrode (110).

10. Appareil de la revendication 1 comprenant en outre une pompe de refroidissement (900) adaptée pour pomper un agent réfrigérant, dans lequel
ladite électrode est sensiblement creuse et adaptée pour être fonctionnellement reliée à ladite pompe de refroidissement ;
ladite électrode est adaptée pour délivrer un agent réfrigérant dans ladite cathode depuis ladite pompe de refroidissement ; et
ledit arbre et ledit ensemble de délivrance de puissance comprennent en outre un ensemble palier isolant à canaux adapté pour permettre audit agent réfrigérant de s'écouler à l'extérieur de ladite cathode ;
ledit agent réfrigérant étant agencé pour s'écouler dans ladite électrode creuse et à travers ledit ensemble palier à canaux, refroidissant ainsi ledit ensemble de délivrance de puissance et ladite cathode.

11. Appareil de la revendication 10 dans lequel ledit ensemble palier à canaux comprend un palier en céramique non conducteur (314) en contact au moins partiel avec ladite électrode.

12. Procédé de dépôt de matière avec un appareil à cathode de pulvérisation magnétron cylindrique rotative (1) comprenant une alimentation électrique radiofréquence (800), un ensemble de délivrance de puissance (100), une cathode rotative (200), un arbre (300) et un moteur d'entraînement (400), dans lequel
ledit ensemble de délivrance de puissance comprend une source de champ magnétique (140) positionnée à l'intérieur de ladite cathode et une électrode (110) s'étendant à l'intérieur de ladite cathode ;
la surface extérieure (206) de ladite cathode comprend un matériau cible (205) ;
ladite électrode est agencée pour être isolée électriquement dudit arbre ;
ledit arbre est agencé pour être généralement coaxial avec ladite cathode ; et
ladite électrode et ledit arbre sont formés à partir de matériaux non ferreux ;
ledit procédé comprenant les étapes consistant à :
fournir de l'énergie radiofréquence à des fréquences de 1 MHz ou plus à l'électrode ;
faire tourner la cathode autour de ladite source de champ magnétique ; et
positionner un substrat (290) à proximité de ladite surface extérieure de ladite cathode ;
ladite énergie radiofréquence éjectant des particules dudit matériau cible sur ledit substrat.

13. Procédé de la revendication 12 dans lequel ladite électrode (110) est agencée pour ne pas être en contact électrique direct avec ladite cathode (200).

14. Procédé de la revendication 12 dans lequel ladite alimentation électrique (800) est adaptée pour fournir de l'énergie radiofréquence à des fréquences de 13 MHz ou plus.

15. Procédé de la revendication 14 dans lequel ladite alimentation électrique est adaptée pour fournir de l'énergie radiofréquence à des fréquences de 25 MHz ou plus.

16. Procédé de la revendication 15 dans lequel ladite alimentation électrique est adaptée pour fournir de l'énergie radiofréquence à des fréquences de 300 MHz ou plus.

17. Procédé de la revendication 16 dans lequel ladite alimentation électrique est adaptée pour fournir de l'énergie radiofréquence à des fréquences de 1 GHz ou plus.

18. Procédé de la revendication 12 dans lequel ledit matériau cible est constitué de matériaux isolants et est sensiblement dépourvu de matériaux conducteurs.

19. Procédé de la revendication 12, dans lequel ledit matériau cible (205) est constitué d'un oxyde.
